# EUROPEAN PATENT APPLICATION

(11) **EP 4 207 246 A1**
(43) Date of publication of application: **05.07.2023**
(21) Application number: 21860952.7
(22) Date of filing: 25.06.2021
(51) Int. Cl.: H01L 21/02, H01L 21/304

(54) **SUBSTRATE PROCESSING METHOD AND SUBSTRATE PROCESSING DEVICE**

(30) Priority: 27.08.2020 JP 2020143517
(71) Applicant: Ebara Corporation, Tokyo 144-8510 (JP)
(72) Inventor: SATAKE, Masayuki, Tokyo 144-8510 (JP); NAKANISHI, Masayuki, Tokyo 144-8510 (JP); YAMASHITA, Michiyoshi, Tokyo 144-8510 (JP)
(74) Representative: Schmidbauer, Andreas Konrad
(86) International application number: PCT/JP2021/024080
(87) International publication number: WO 2022/044522

(57) **Abstract**

The present invention relates to a substrate processing method for suppressing cracking and chipping of a laminated substrate manufactured by bonding a plurality of substrates. Further, the present invention relates to a substrate processing apparatus capable of performing such a substrate processing method. The present method includes: rotating a laminated substrate (Ws) manufactured by bonding a first substrate (W1) and a second substrate (W2); applying a filler (F), having thermosetting property, to a gap between a peripheral portion of the first substrate (W1) and a peripheral portion of the second substrate (W2); and curing the filler (F). Applying the filler (F) and curing the filler (F) are continuously performed in a same processing chamber (21).

## Description

### Background Art

The present invention relates to a substrate processing method for suppressing cracking and chipping of a laminated substrate manufactured by bonding a plurality of substrates. Further, the present invention relates to a substrate processing apparatus capable of performing such a substrate processing method.

### Background Art

Recently, in order to achieve further higher density and functionality in semiconductor devices, development of three-dimensional packaging technology in which a plurality of substrates are laminated and integrated three-dimensionally, has been advanced. In the three-dimensional packaging technology, a device surface of a first substrate on which integrated circuits and electrical wiring are formed is, for example, bonded to a device surface of a second substrate on which integrated circuits and electrical wiring are similarly formed. Further, after the first substrate is bonded to the second substrate, the second substrate is thinned by a polishing apparatus or a grinding apparatus. In this manner, integrated circuits can be laminated in the direction perpendicular to the device surfaces of the first and second substrates.

In the three-dimensional packaging technology, three or more substrates may be bonded to each other. For example, a third substrate may be bonded to the second substrate after the second substrate bonded to the first substrate has been thinned, and then the third substrate may be thinned. In this specification, a substrate form in which a plurality of substrates are bonded to each other may be referred to as a "laminated substrate".

### Citation List

### Patent Literature

Patent document 1: Japanese laid-open patent publication No. 2014-63955

### Summary of Invention

### Technical Problem

Generally, a circumferential surface of the substrate is polished in advance in a rounded shape in order to prevent cracking or chipping thereof. When the second substrate having such circumferential surface with the rounded shape is grinded, an acute edge is formed on the second substrate as a result of the grinding. This acute edge portion (which will be hereinafter referred to as a "knife-edge portion") is constituted by the grinded back surface and the circumferential surface of the second substrate. Such knife-edge portion is likely to be chipped by a physical contact, and the laminated substrate itself may be broken during transportation of the laminated substrate. Further, insufficient bonding between the first substrate and the second substrate may cause the second substrate to be cracked during grinding.

It is therefore an object of the present invention to provide a substrate processing method for suppressing cracking and chipping of a laminated substrate manufactured by bonding a plurality of substrates.

It is also an object of the present invention to provide a substrate processing apparatus capable of performing the method mentioned above.

### Solution to Problem

In one embodiment, there is provided a substrate processing method, comprising: rotating a laminated substrate manufactured by bonding a first substrate and a second substrate; applying a filler, having thermosetting property, to a gap between a peripheral portion of the first substrate and a peripheral portion of the second substrate; and curing the filler, wherein applying the filler and curing the filler are continuously performed in a same processing chamber.

In one embodiment, applying the filler comprises injecting the filler by use of a syringe mechanism, the syringe mechanism includes: a syringe body filled with the filler; and a piton movable in the syringe body, and a tip opening of the syringe body is opposite to the gap.

In one embodiment, applying the filler comprises ejecting the filler by use of ejection mechanism, the ejection mechanism includes an ejector filled with the filler, and the ejector has an ejection port opposite to the gap.

In one embodiment, applying the filler comprises conveying the filler by use of a conveyance mechanism, the conveyance mechanism includes: a tube having a discharge port and filled with the filler; and a filler conveyance member which extends from the discharge port, and which is in close proximity to or contacts the gap.

In one embodiment, curing the filler comprises curing the filler by use of a lamp heater.

In one embodiment, the lamp heater irradiates a light having a wavelength of 1 µm or more from above or below the laminated substrate toward the filler.

In one embodiment, curing the filler comprises curing the filler by use of a heat-gun.

In one embodiment, there is provided a substrate processing apparatus, comprising: a substrate holder configured to hold and rotate a laminated substrate manufactured by bonding a first substrate and a second substrate; an application module configured to apply a filler, having thermosetting property, to a gap between a peripheral portion of the first substrate and a peripheral portion of the second substrate; a cure module configured to cure the filler; and a processing chamber in which the substrate holder, the application module, and the cure module are disposed, wherein applying and curing of the filler are continuously performed in the processing chamber while rotating the laminated substrate.

In one embodiment, the application module includes a syringe mechanism, the syringe mechanism includes: a syringe body filled with the filler; and a piston movable in the syringe body, and a tip opening of the syringe body is oppose to the gap.

In one embodiment, the application module includes an ejection mechanism, the ejection mechanism includes an ejector filled with the filler, and the ejector has an ejection port opposite to the gap.

In one embodiment, the application module includes a conveyance mechanism, and the conveyance mechanism includes: a tube having a discharge port and filled with the filler; and a filler conveyance member which extends from the discharge port, and which is in close proximity to or contacts the gap.

In one embodiment, the cure module includes a lamp heater, and the lamp heater includes: a lamp; and an optical device that directs heat from the lamp to the filler.

In one embodiment, the lamp is configured to irradiate a light having a wavelength of 1 µm or more, and the lamp heater is disposed above or below the laminated substrate.

In one embodiment, the cure module includes a heat-gun configured to blow a heated gas toward the filler.

### Advantageous Effects of Invention

According to the present invention, the filler cured in the gap between the peripheral portion of the first substrate and the peripheral portion of the second substrate makes it possible to protect a knife-edge portion formed in the peripheral portion of the second substrate. As a result, cracking and chipping of the laminated substrate can be suppressed. Further, the peripheral portion of the first substrate and the peripheral portion of the second substrate are supported against each other through the cured filler. As a result, strength of the laminated substrate is increased, and thus cracking and chipping of the laminated substrate during thinning of the second substrate can be effectively suppressed.

### Brief Description of Drawings

[FIG. 1A] FIG. 1A is an enlarged cross-sectional view showing a peripheral portion of a substrate;
[FIG. 1B] FIG. 1B is an enlarged cross-sectional view showing a peripheral portion of a substrate;
[FIG. 2A] FIG. 2A is a schematic view showing an example of a laminated substrate in which two wafers are bonded to each other;
[FIG. 2B] FIG. 2B is a schematic view showing the laminated substrate after the second wafer shown in FIG. 2A has been thinned;
[FIG. 3A] FIG. 3A is a schematic view showing another example of the laminated substrate in which two wafers are bonded to each other;
[FIG. 3B] FIG. 3B is a schematic view showing the laminated substrate after the second wafer shown in FIG. 3A has been thinned;
[FIG. 4] FIG. 4 is a plan view showing a substrate processing apparatus according to an embodiment,
[FIG. 5] FIG. 5 is a longitudinal cross-sectional view schematically showing the substrate processing apparatus shown in FIG. 4;
[FIG. 6] FIG. 6 is a schematic view showing an application module according to an embodiment;
[FIG. 7] FIG. 7 is a schematic view showing a cure module according to an embodiment;
[FIG. 8A] FIG. 8A is a schematic view showing a filler which has been cured in a gap between a peripheral portion of the first wafer and a peripheral portion of the second wafer in the laminated substrate shown in FIG. 2A;
[FIG. 8B] FIG. 8B is a schematic view showing a state where the second wafer of the laminated substrate shown in FIG. 8A has been thinned;
[FIG. 9A] FIG. 9A is a schematic view showing a filler which has been cured in a gap between a peripheral portion of the first wafer and a peripheral portion of the second wafer in the laminated substrate shown in FIG. 3A;
[FIG. 9B] FIG. 9B is a schematic view showing a state where the second wafer of the laminated substrate shown in FIG. 9A has been thinned;
[FIG. 10] FIG. 10 is a schematic view showing the application module according to another embodiment;
[FIG. 11] FIG. 11 is a schematic view of an application module according to still another embodiment; and
[FIG. 12] FIG. 12 is a schematic view showing a cure module according to another embodiment.

### Description of Embodiments

Embodiments will be described below with reference to the drawings.

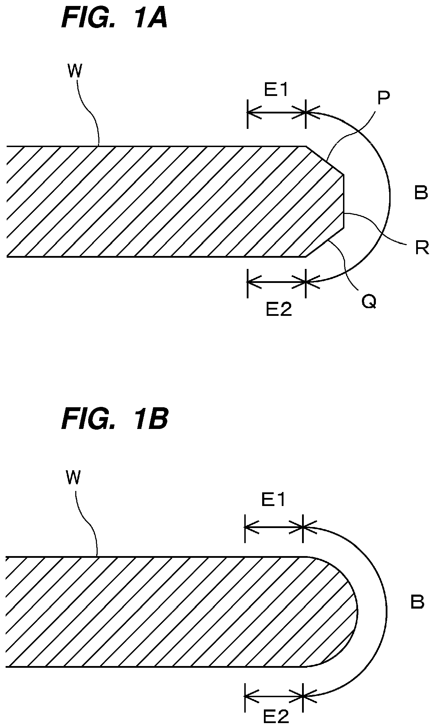

FIGS. 1A and 1B are enlarged cross-sectional views each showing a peripheral portion of a wafer which is an example of a substrate. More specifically, FIG. 1A is a cross sectional view of a wafer of a so-called straight type, and FIG. 1B is a cross sectional view of a wafer of a so-called round type. In a wafer W shown in FIG. 1A, a bevel portion is an outermost circumferential surface (indicated by symbol B) including an upper slope (or an upper bevel portion) P, a lower slope (or a lower bevel portion) Q, and a side portion (or an apex) R of the wafer W.

In a wafer W shown in FIG. 1B, a bevel portion is a portion B constituting an outermost circumferential surface of the wafer W and having a curved cross section. A top edge portion E1 is a flat portion located radially inwardly of the bevel portion B and located radially outwardly of a region D where devices are formed. The top edge E1 may include an area where devices are formed. A bottom edge portion E2 is a flat portion located radially inwardly of the bevel portion B and located at an opposite side from the top edge portion E1. The top edge portion E1 and the bottom edge portion E2 may be collectively referred to as a near edge portion

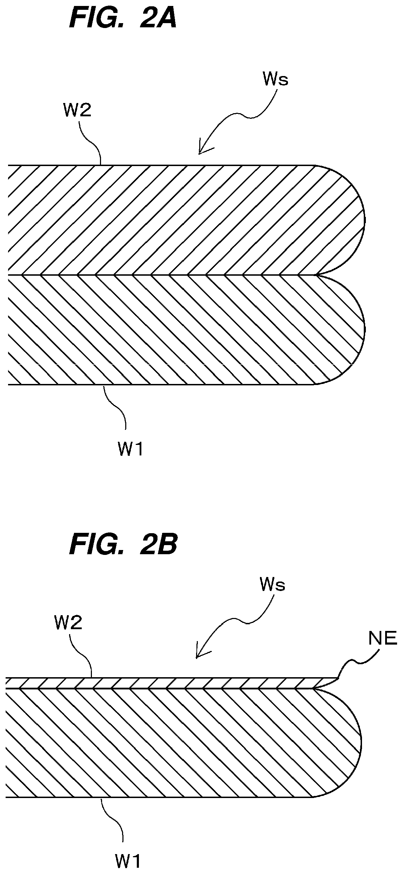

FIG. 2A is a schematic view showing an example of a laminated substrate in which two wafers are bonded to each other, and FIG. 2B is a schematic view showing the laminated substrate after the second wafer shown in FIG. 2A has been thinned. The laminated substrate Ws shown in FIG. 2A is manufactured by bonding a first wafer W1 and a second wafer W2 of which are the round type shown in FIG. 1B.

As shown in FIG. 2B, when the second wafer W2 is thinned, a knife-edge portion NE is formed in peripheral portion of the second wafer W2. This knife-edge portion NE is likely to be chipped by physical contact, and may cause the laminated substrate Ws to be cracked or chipped during transportation of the laminated substrate Ws and during further processing of the laminated substrate Ws. Further, insufficient bonding between the first wafer W1 and the second wafer W2 may cause the second wafer W2 to be cracked or chipped during a grinding process of the second wafer W2 (i.e., a thinning process). In a case also where the laminated substrate Ws is manufactured by bonding a first wafer W1 and a second wafer W2 of which are the square type shown in FIG. 1A, a knife-edge portion is formed in the peripheral portion of the second wafer W2 after the second wafer W2 has been thinned.

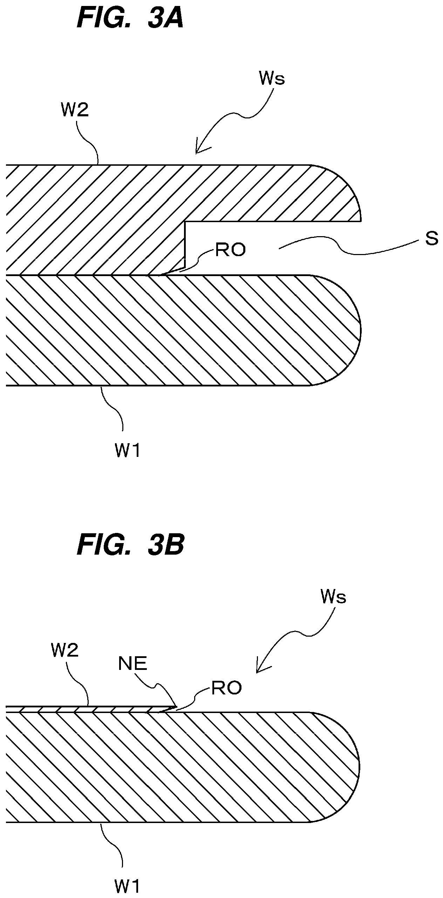

FIG. 3A is a schematic view showing another example of the laminated substrate in which two wafers are bonded to each other, and FIG. 3B is a schematic view showing the laminated substrate after the second wafer shown in FIG. 3A has been thinned. Although the laminated substrate Ws shown in FIG. 3A is also manufactured by bonding the first wafer W1 and the second wafer W2 of the round type shown in FIG. 1B, the peripheral portion of the second wafer W2 is polished before the second wafer W2 is bonded to the first wafer W1. Thus, the peripheral portion of the second wafer W2 has a step S formed around the entire circumference of the peripheral portion of the second wafer W2. Further, when the peripheral portion of the second wafer W2 is polished to form the step S, a roll-off portion RO may be formed in a surface of the second wafer W2 inside of radial direction than the step S.

As shown in FIG. 3B, this roll-off portion RO can become the knife-edge portion NE, which is an acute edge, after the second wafer W2 has been thinned. Therefore, even if the peripheral portion of the second wafer W2 is polished in advance, it is not sufficient to suppress cracking and chipping of the laminated substrate Ws.

Therefore, in this embodiment, a filler is applied between the first wafer W1 and the second wafer W2 of the laminated substrate Ws, and then this filler is cured, thereby effectively protecting the knife-edge portion NE.

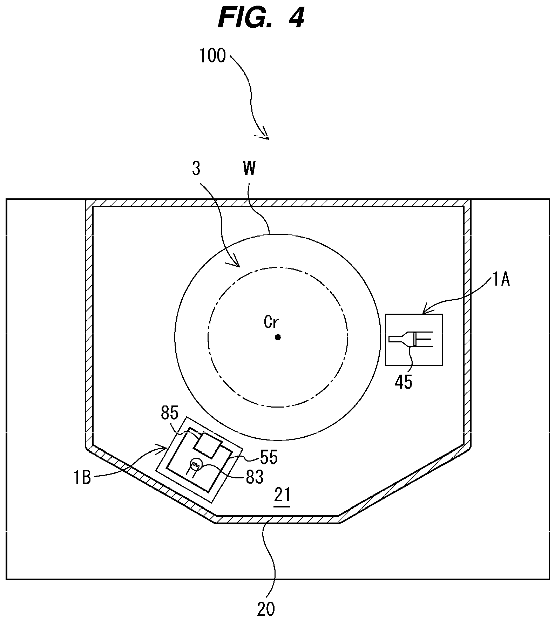

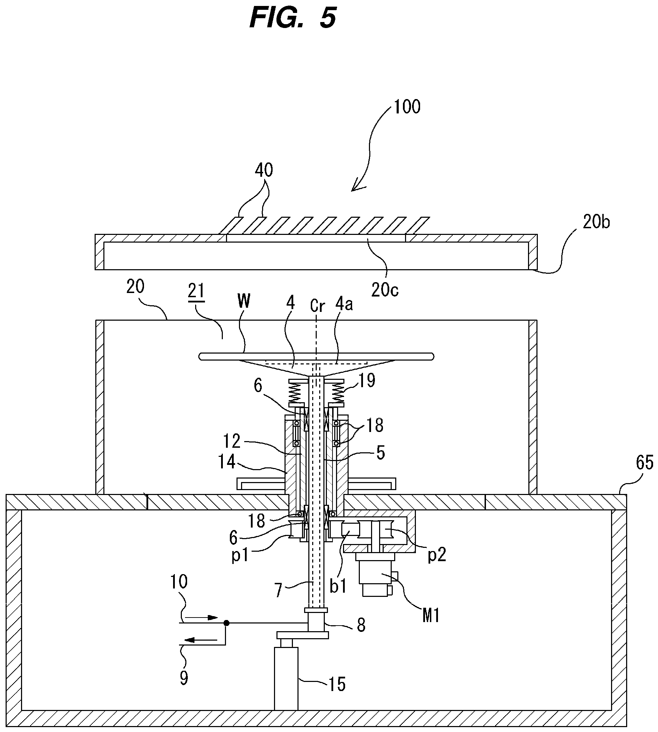

FIG. 4 is a plan view showing a substrate processing apparatus according to an embodiment, and FIG. 5 is a longitudinal cross-sectional view schematically showing the substrate processing apparatus shown in FIG. 4. The substrate processing apparatus shown in FIGS. 4 and 5 serves as an apparatus for applying and further curing a filler to a gap formed between the wafers W1 and W2 of the laminated substrate Ws. In FIG. 5, illustrations of an application module 1A and a cure module 1B, which will be described below, are omitted.

As shown in FIG. 4 and FIG. 5, this substrate processing apparatus 100 includes a rotary holding mechanism (a substrate holder) 3 configured to horizontally hold a laminated substrate Ws (see FIG. 2A or FIG.3A), in which a plurality of wafers W1, W2 are laminated, and to rotate the laminated substrate Ws. FIG. 4 illustrates a state in which the rotary holding mechanism 3 holds the laminated substrate Ws. The rotary holding mechanism 3 has a dish-shaped holding stage 4 configured to hold a back surface of the laminated substrate Ws by a vacuum suction, a hollow shaft 5 coupled to a central portion of the holding stage 4, and a motor M1 for rotating the hollow shaft 5. The laminated substrate Ws is placed onto the holding stage 4 by hands of a transporting mechanism (not shown) such that a center of the laminated substrate Ws is aligned with a central axis of the hollow shaft 5.

The hollow shaft 5 is supported by ball spline bearings (i.e., linear motion bearings) 6 which allow the hollow shaft 5 to move vertically. The holding stage 4 has an upper surface having grooves 4a. These grooves 4a communicate with a communication passage 7 extending through the hollow shaft 5. The communication passage 7 is coupled to a vacuum line 9 via a rotary joint 8 provided on a lower end of the hollow shaft 5. The communication passage 7 is also coupled to a nitrogen-gas supply line 10 for use in releasing the laminated substrate Ws from the holding stage 4 after processing. By selectively coupling the vacuum line 9 and the nitrogen-gas supply line 10 to the communication passage 7, the laminated substrate Ws can be held on the upper surface of the holding stage 4 by the vacuum suction and can be released from the upper surface of the holding stage 4.

A pulley p1 is coupled to the hollow shaft 5, and a pulley p2 is mounted on a rotational shaft of the motor M1. The hollow shaft 5 is rotated by the motor M1 through the pulley p1, the pulley p2, and a belt b1 riding on these pulleys p1 and p2. With these structures, the laminated substrate Ws, held on the upper surface of the holding stage 4, is rotated by the motor M1.

The ball spline bearing 6 is a bearing that allows the hollow shaft 5 to move freely in its longitudinal direction. The ball spline bearings 6 are secured to a cylindrical casing 12. Therefore, in this embodiment, the hollow shaft 5 can move linearly up and down relative to the casing 12, and the hollow shaft 5 and the casing 12 rotate in unison. The hollow shaft 5 is coupled to an air cylinder (elevating mechanism) 15, so that the hollow shaft 5 and the holding stage 4 are elevated and lowered by the air cylinder 15.

A cylindrical casing 14 is provided so as to surround the casing 12 in a coaxial arrangement. Radial bearings 18 are provided between the casing 12 and the cylindrical casing 14, so that the casing 12 is rotatably supported by the radial bearings 18. With these structures, the rotary holding mechanism 3 can rotate the laminated substrate Ws about its central axis Cr, and can elevate and lower the laminated substrate Ws along the central axis Cr.

As shown in FIG. 4, the substrate processing apparatus 100 includes an application module (application section) 1A, and a cure module (cure section) 1B, which are placed around the laminated substrate Ws held by the rotary holding mechanism 3. The cure module 1B is located downstream of the application module 1B in a direction of rotation of the laminated substrates Ws.

The application module 1A is a device for applying a filler to a gap formed between the peripheral portion of the first wafer W1 and the peripheral portion of the second wafer W2. The cure module 1B is a device for curing the filler supplied to the laminated substrate Ws by the application module 1A. In this embodiment, the filler is a filler having thermosetting property. Examples of such filler may include a thermosetting resin.

The application module 1A and the cure module 1B are disposed in a processing chamber 21, which is partitioned by a partition 20, Accordingly, the processing chamber 21 is isolated from outer environment by the partition 20. The application module 1A, the cure module 1B, and the holding stage 4 are disposed in the processing chamber 21. In other words, the laminated substrate Ws during processing is housed in the processing chamber 21.

In order to isolate mechanical devices, such as the ball spline bearings 6 and the radial bearings 18, from the processing chamber 21 when the hollow shaft 5 is elevated and lowered relative to the casing 12, the hollow shaft 5 and an upper end of the casing 12 are coupled to each other by a bellows 19 that is extensible and contractible in a vertical direction, as shown in FIG. 5. FIG. 5 illustrates a state in which the hollow shaft 5 is in a lowered position and the holding stage 4 is in a processing position. After the application process and cure process of the filler, the air cylinder 15 elevates the laminated substrate Ws, together with the holding stage 4 and the hollow shaft 5, to a transport position, where the laminated substrate Ws is released from the holding stage 4.

The partition 20 has an entrance 20b through which the laminated substrate Ws is transported into and removed from the processing chamber 21. The entrance 20b is a horizontally extending cutout. Therefore, the laminated substrate Ws, held by the transporting mechanism, can travel horizontally across the processing chamber 21 through the entrance 20b. An upper surface of the partition 20 has an aperture 20c and louvers 40, and a lower surface of the partition 20 has a gas-discharge opening (not shown in the drawing). During the application process and the cure process of the filler, the entrance 20b is closed by a non-illustrated shutter. Therefore, as a fan mechanism (not shown in the drawing) is driven to evacuate an air through the gas-discharge opening, downward flow of clean air is formed in the processing chamber 21. The fan mechanism serves as a pressure regulator for maintaining a pressure in the processing chamber 21 at positive pressure. Since the laminated substrates Ws are processed in this state, the processing of the laminated substrates Ws can be performed while an upper space of the processing chamber 21 is kept clean.

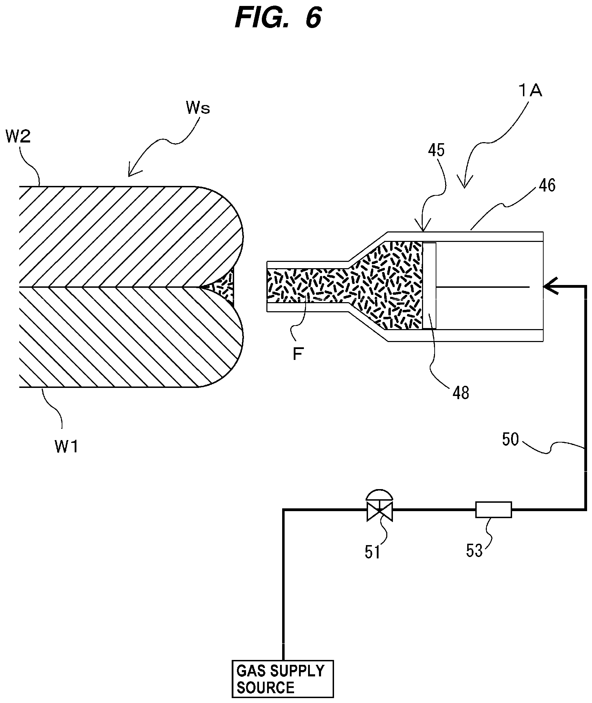

FIG. 6 is a schematic view showing an application module according to an embodiment. The application module 1A shown in FIG. 6 has a syringe mechanism 45 for injecting a filler into a gap between the first wafer W1 and the second wafer W2, and a horizontal movement mechanism (not shown) for moving the syringe mechanism 45 so as to be approached to or separated from the laminated substrate Ws. In one embodiment, the horizontal movement mechanism may be omitted. In this case, a position of the syringe mechanism 45 relative to the holding stage 4 is determined in advance such that the filler can be properly injected into the gap between the first wafer W1 and the second wafer W2.

The syringe mechanism 45 has a syringe body 46 having a hollow structure, and a piston 48 movable reciprocally in the syringe body 46. The syringe body 46 is coupled to a gas supply source through a gas supply line 50. Supplying of gas (e.g., dry air or nitrogen gas) into the syringe body 46 from the gas supply source causes the piston 48 to be moved forward in the syringe body 46. The syringe body 46 has a tip opening opposite to the gap between the peripheral portion of the first wafer W1 and the peripheral portion of the second wafer W2. The syringe body 46 is filled with the filler F in advance, and the forward movement of the piston 48 causes the filler F to be injected from the tip opening of the syringe body 46 into the gap between the peripheral portion of the first wafer W1 and the peripheral portion of the second wafer W2.

A pressure regulator (e.g., pressure reducing valve) 51 and a flow regulator (e.g., mass flow controller) 53 are disposed in the gas supply line 50. A pressure and a flow rate of the gas supplied from the gas supply source into the syringe body 46 can be regulated to thereby control a flow rate of the filler F to be discharged from the syringe body 46.

When applying the filler F to the gap between the first wafer W1 and the second wafer W2, the holding stage 4 holding the laminated substrate Ws is first rotated at a predetermined rotation speed. Next, the syringe mechanism 45 is brought into approach to the laminated substrates Ws, and further, the gas is supplied into the syringe body 46 from the gas supply source. These operations cause the filler F to be injected into the gap between the peripheral portion of the first wafer W1 and the peripheral portion of the second wafer W2 in the rotating laminated substrate Ws.

If an amount of the filler F injected from the syringe mechanism 45 into the gap between the peripheral portion of the first wafer W1 and the peripheral portion of the second wafer W2 is too much, the filler F overflowing from the gap may contaminate an upper surface and a lower surface of the laminated substrate Ws. If an amount of the filler F injected from the syringe mechanism 45 into the gap between the peripheral portion of the first wafer W1 and the peripheral portion of the second wafer W2 is too little, there is a risk of not being able to apply a sufficient amount of the filler F to the gap. Therefore, in this embodiment, the flow rate of the filler F discharged from the syringe body 46 and the rotation speed of the holding stage 4 are adjusted in advance such that a necessary and sufficient amount of filler F is supplied into the gap between the peripheral portion of the first wafer W1 and the peripheral portion of the second wafer W2 in the rotating laminated substrate Ws.

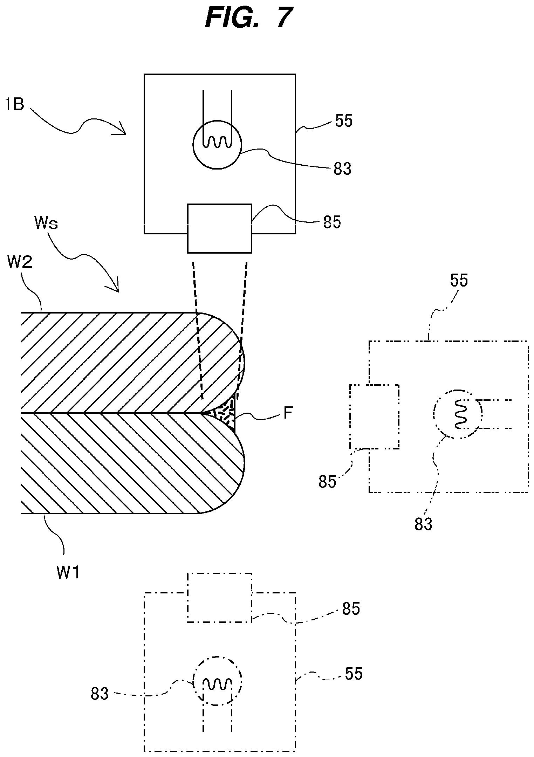

FIG. 7 is a schematic view showing a cure module according to an embodiment. The cure module 1B shown in FIG. 7 is configured as a light-heating module having a lamp heater 55. The lamp heater 55 includes a lamp 83, and an optical device 85 that directs heat (radiant heat) from the lamp 83 to the filler F applied to the gap between the first wafer W1 and the second wafer W2. Although not shown in drawings, the optical device 85 is, for example, constituted of mirrors and/or lenses.

The lamp heater 55 shown in FIG. 7 is disposed above the second wafer W2 of the laminated substrate Ws, and the lamp 83 irradiates light having a wavelength of 1 µm or more from above the laminated substrate Ws through the optical device 85. If the lamp 83 irradiates light having a wavelength of 1µm or more, that light irradiated from the lamp 83 can directly heat the filler F applied to the gap between the peripheral portion of the first wafer W1 and the peripheral portion of the second wafer W2 because the light irradiated from the lamp 83 transmits through the second wafer W2. The light-heating module having the lamp 83 has high thermal efficiency, and thus can heat and cure the filler F in a short period of time. Therefore, throughput of the substrate processing apparatus 100 can be increased.

A position of the lamp heater 55 with respect to the laminated substrate Ws can be freely selected. For example, as shown by a single-dotted line in FIG. 7, the lamp heater 55 may be disposed below the first wafer W1. In this case, the light irradiated from the lamp 83 transmits through the first wafer W1 to directly heat the filler F. Alternatively, the lamp heater 55 may be disposed such that the lamp 83 is opposite to the gap between the peripheral portion of the first wafer W1 and the peripheral portion of the second wafer W2, as shown by a double-dotted line in FIG. 7. In this case, the lamp 83 heats the filler F from a lateral side of the laminated substrate Ws. Therefore, any lamp can be used as the lamp 83 because the light irradiated from the lamp 83 is not necessary to transmit through the first wafer W1 or the second wafer W2.

In the substrate processing apparatus 100 configured in this manner, the laminated substrate Ws is first held to the holding stage 4 of the rotary holding mechanism 3 by vacuum suction. Next, the laminated substrates Ws are rotated together with the holding stage 4. Next, the application module 1A applies the filler F to the gap between the peripheral portion of the first wafer W1 and the peripheral portion of the second wafer W2 in the laminated substrate Ws, and then the cure module 1B cures the applied filler F. The application process and the cure process of the filler F are continuously performed in the same processing chamber 21. Therefore, processes of the substrate for suppressing cracking and chipping of the laminated substrate Ws can be performed in a greatly short period of time.

Thereafter, the laminated substrate Ws is transported out of the substrate processing apparatus 100, and the second wafer W2 of the laminated substrate Ws is thinned in another semiconductor manufacturing apparatus.

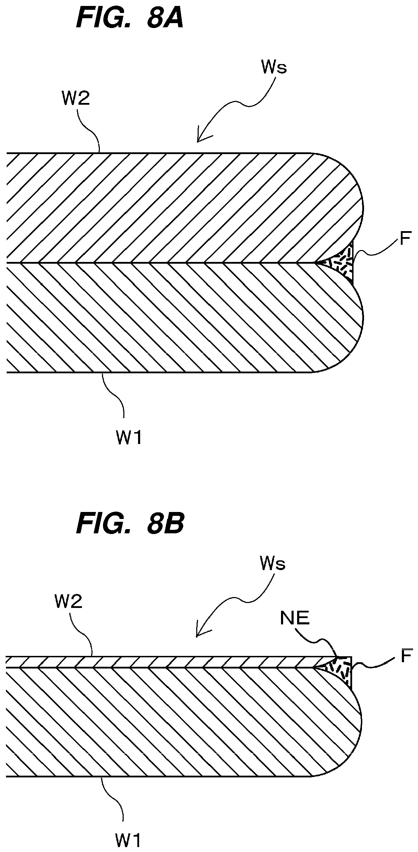

FIG. 8A is a schematic view showing the filler which has been cured in the gap between the peripheral portion of the first wafer and the peripheral portion of the second wafer in the laminated substrate shown in FIG. 2A, and FIG. 8B is a schematic view showing a state where the second wafer of the laminated substrate shown in FIG. 8A has been thinned. As shown in FIG. 8B, even after the second wafer W2 is thinned, the filler F cured in the gap between the peripheral portion of the first wafer W1 and the peripheral portion of the second wafer W2 makes it possible to protect the knife-edge portion NE formed in the peripheral portion of the second wafer W2. As a result, cracking and chipping of the laminated substrate Ws can be suppressed. Further, as shown in FIG. 8A, the peripheral portion of the first wafer W1 and the peripheral portion of the second wafer W2 are supported against each other through the cured filler F. As a result, strength of the laminated substrate Ws is increased, and thus cracking and chipping of the laminated substrate Ws during thinning of the second wafer W2 can be effectively suppressed.

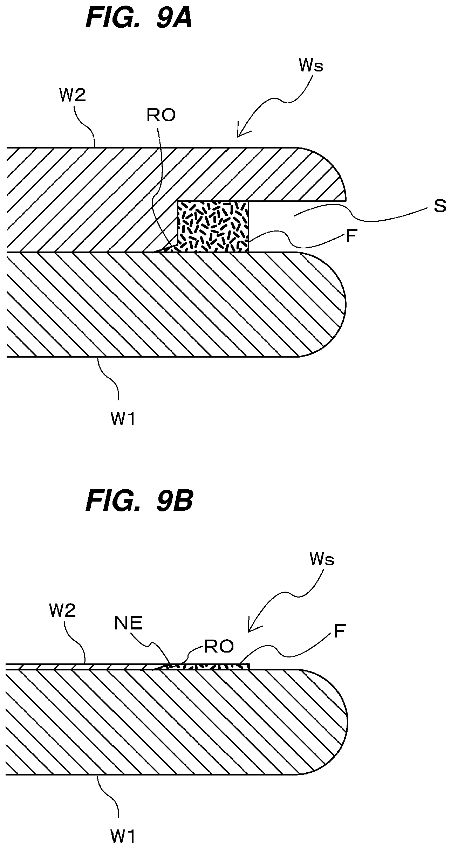

FIG. 9A is a schematic view showing the filler which has been cured in the gap between the peripheral portion of the first wafer and the peripheral portion of the second wafer in the laminated substrate shown in FIG. 3A, and FIG. 9B is a schematic view showing a state where the second wafer of the laminated substrate shown in FIG. 9A has been thinned. As shown in FIG. 9A, the filler F is cured in the gap between the peripheral portion of the first wafer W1 and the peripheral portion of the second wafer W2, which includes the step S and the roll-off portion RO. Therefore, strength of the laminated substrate Ws is increased, and thus cracking and chipping of the laminated substrate Ws during thinning of the second wafer W2 can be effectively suppressed. Further, as shown in FIG. 9B, even when the second wafer W2 is thinned until reaching the roll-off portion RO, the filler F makes it possible to protect the knife-edge portion NE formed in the peripheral portion of the second wafer W2. As a result, cracking and chipping of the laminated substrate Ws can be suppressed.

In the embodiment described with reference to FIGS. 4 to 7, the application module 1A has the syringe mechanism 45. However, this embodiment is not limited to this example. Configuration of the application module 1A is freely selected from any configuration as long as the application module can apply the filler F to the gap between the peripheral portion of the first wafer W1 and the peripheral portion of the second wafer W2 in the laminated substrate Ws.

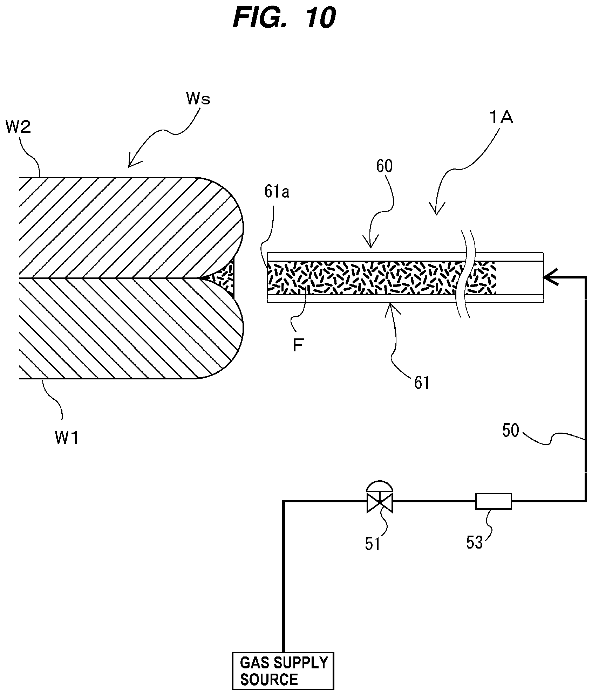

FIG. 10 is a schematic view showing the application module according to another embodiment. The application module 1A shown in FIG. 10 differs from the application module 1A shown in FIG. 6 in that, instead of the syringe mechanism 45, the application module 1A has an ejection mechanism 60 that ejects the filler F into the gap between the peripheral portion of the first wafer and the peripheral portion of the second wafer in the laminated substrate Ws.

The ejection mechanism 60 shown in FIG. 10 has a tubular ejector 61 having an ejection port 61a. The ejection port 61a is opposite to the gap between the peripheral portion of the first wafer and the peripheral portion of the second wafer in the laminated substrate Ws. The ejector 61 has a filler F filled therein in advance, and is coupled to a gas supply source through a gas supply line 50. Supplying of gas (e.g., dry air or nitrogen gas) from the gas supply source into the ejector 61 causes the filler F to be continuously ejected from the ejection port 61a to the gap between the peripheral portion of the first wafer W1 and the peripheral portion of the second wafer W2.

Although not shown in the drawings, the ejector 61 may be a piston-cylinder unit. In this case, gas supplied to the ejector 61 from the gas supply source causes a piston to move forward in a cylinder, continuously ejecting the filler F filled in the cylinder from the ejection port 61a.

A pressure regulator (e.g., pressure reducing valve) 51 and a flow regulator (e.g., mass flow controller) 53 are disposed in the gas supply line 50. A pressure and a flow rate of the gas supplied from the gas supply source into the ejector 61 can be regulated to thereby control a flow rate of the filler F to be discharged from the ejection port 61a. In this embodiment also, the flow rate of the filler F discharged from the ejection port 61a and the rotation speed of the holding stage 4 are adjusted in advance such that a necessary and sufficient amount of filler F is supplied into the gap between the peripheral portion of the first wafer W1 and the peripheral portion of the second wafer W2 in the rotating laminated substrate Ws.

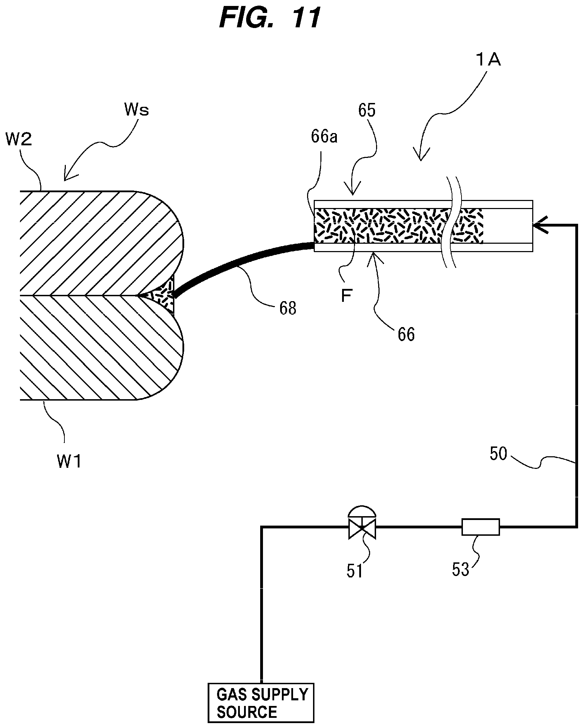

FIG. 11 is a schematic view of an application module according to still another embodiment. The application module 1A shown in FIG. 11 differs from the application module 1A shown in FIG. 6 in that, instead of the syringe mechanism 45, the application module 1A has a conveyance mechanism 65 for the filler F.

The conveyance mechanism 65 shown in FIG. 11 has a tube 66 having a discharge port 66a, and a filler conveyance member 68 coupled to the discharge port 66a. The filler conveyance member 68 is a rod-shaped member extending obliquely downward from a lower end of the discharge port 66a, and a tip of the filler conveyance member 68 is in close proximity to or contacts the gap between the peripheral portion of the first wafer W1 and the peripheral portion of the second wafer W2 in the laminated substrate Ws. The filler conveyance member 68 is made of a material having a hydrophilic property. In one embodiment, the filler conveyance member 68 may have a surface treated with a hydrophilic treatment, such as a coating of a material having a hydrophilic property. The filler conveyance member 68 has a size that allows insertion into the gap between the peripheral portion of the first wafer W1 and the peripheral portion of the second wafer W2, for example. The filler conveyance member 68 is preferably flexible so as not to damage the laminated substrate Ws.

The tube 66 has a filler F filled therein in advance, and is coupled to a gas supply source through a gas supply line 50. Supplying of gas (e.g., dry air or nitrogen gas) from the gas supply source into the tube 66 causes the filler F to flow out of the discharge port 66a and flow on the surface of the filler conveyance member 68. Since the tip of the filler conveyance member 68 is close proximity to or contacts the gap between the peripheral portion of the first wafer W1 and the peripheral portion of the second wafer W2, the filler F can be conveyed to the gap between the peripheral portion of the first wafer W1 and the peripheral portion of the second wafer W2 through the filler conveyance member 68. In this embodiment also, the flow rate of the filler F flowing out of the tube 66 and the rotation speed of the holding stage 4 are adjusted in advance such that a necessary and sufficient amount of filler F is supplied to the gap between the peripheral portion of the first wafer W1 and the peripheral portion of the second wafer W2 in the rotating laminated substrate Ws. With this configuration, the amount of filler F supplied to the gap between the peripheral portion of the first wafer W1 and the peripheral portion of the second wafer W2 can be more accurately controlled.

Although not shown in the drawings, the conveyance mechanism 65 may have, instead of the tube 66, a piston-cylinder unit. In this case, the filler conveyance member 68 is coupled to a tip opening of a cylinder of the piston-cylinder unit. Supplying of gas from the gas supply source to the piston-cylinder unit causes a piston to move forward in the cylinder, thereby supplying the filler F filled in the cylinder to the filler conveyance member 68 from the tip opening of the cylinder.

In the embodiment described with reference to FIGS. 4 to 7, the cure module 1B is configured as a light-heating module having the lamp 83. However, this embodiment is not limited to this example. Configuration of the cure module 1B is freely selected from any configuration as long as the cure module 1B can cure the filler F applied to the gap between the peripheral portion of the first wafer W1 and the peripheral portion of the second wafer W2 in the laminated substrate Ws.

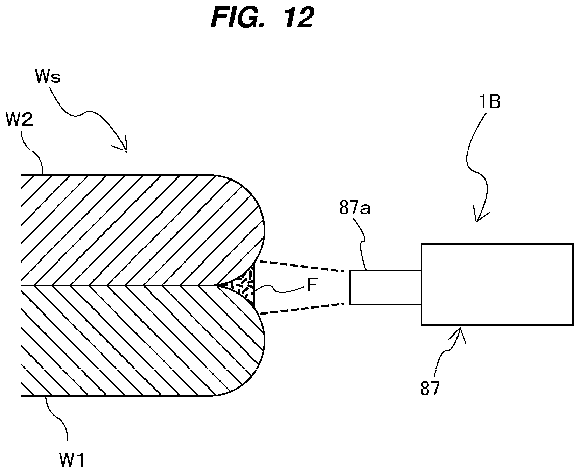

FIG. 12 is a schematic view showing a cure module according to another embodiment. The cure module 1B shown in FIG. 12 differs from the cure module 1B shown in FIG. 7 in that, instead of the lamp heater 55, the cure module 1B has a heat-gun 87 that blows heated gas toward the filler F applied to the gap between the peripheral portion of the first wafer W1 and the peripheral portion of the second wafer W2.

The heat-gun 87 shown in FIG. 12 has an ejection port 87a opposite to the filler F applied to the gap between the peripheral portion of the first wafer W1 and the peripheral portion of the second wafer W2 in the laminated substrate Ws. Further, the heat-gun 87 has a heater (not shown) disposed therein, and a fan unit (not shown) for sending gas, heated by the heater, toward the ejection port 87a. The heat-gun 87 cures the filler F by heated gas ejected from the ejection port 87a thereof while pressing the filler F toward a center of the laminated substrate Ws.

When the cure module 1B is the light-heating module as shown in FIG. 7, the filler F applied to the gap between the peripheral portion of the first wafer W1 and the peripheral portion of the second wafer W2 in the laminated substrate Ws can be heated and cured instantaneously. However, if the curing speed of the filler F is too fast, the filler F may evaporate rapidly, thereby generating voids in the filler F after curing. The heat-gun 87 is configured to be able to regulate an amount of heated gas blown out of the ejection port 87a, and a temperature of the heated gas. Therefore, the heat-gun 87 can heat the filler F more slowly than the light-heating by use of the lamp 83, and can properly press the filler F toward the center of the laminated substrate Ws with the heated gas. The actions of the heat-gun 87 effectively prevent voids from being generated in the filler F after curing.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing method for suppressing cracking and chipping of a laminated substrate manufactured by bonding a plurality of substrates. Further, the present invention is applicable to a substrate processing apparatus capable of performing such a substrate processing method.

### Reference Signs List

- 1A: application module
- 1B: cure module
- 3: rotary holding mechanism (a substrate holder)
- 4: holding stage
- 20: partition
- 21: processing chamber
- 45: syringe mechanism
- 46: syringe body
- 48: piston
- 50: gas supply line
- 51: pressure regulator
- 53: flow regulator
- 55: lamp heater
- 60: ejection mechanism
- 61: ejector
- 65: conveyance mechanism
- 66: tube
- 68: filler conveyance member
- 83: lamp
- 85: optical device
- 87: heat-gun
- 100: substrate processing apparatus

## Claims

1. A substrate processing method, comprising:
rotating a laminated substrate manufactured by bonding a first substrate and a second substrate;
applying a filler, having thermosetting property, to a gap between a peripheral portion of the first substrate and a peripheral portion of the second substrate; and
curing the filler,
wherein applying the filler and curing the filler are continuously performed in a same processing chamber.

2. The substrate processing method according to claim 1, wherein applying the filler comprises injecting the filler by use of a syringe mechanism,
the syringe mechanism includes:
a syringe body filled with the filler; and
a piton movable in the syringe body, and
a tip opening of the syringe body is opposite to the gap.

3. The substrate processing method according to claim 1, wherein applying the filler comprises ejecting the filler by use of ejection mechanism,
the ejection mechanism includes an ejector filled with the filler, and
the ejector has an ejection port opposite to the gap.

4. The substrate processing method according to claim 1, wherein applying the filler comprises conveying the filler by use of a conveyance mechanism,
the conveyance mechanism includes:
a tube having a discharge port and filled with the filler; and
a filler conveyance member which extends from the discharge port, and which is in close proximity to or contacts the gap.

5. The substrate processing method according to any one of claims 1 to 4, wherein curing the filler comprises curing the filler by use of a lamp heater.

6. The substrate processing method according to claim 5, wherein the lamp heater irradiates a light having a wavelength of 1 µm or more from above or below the laminated substrate toward the filler.

7. The substrate processing method according to any one of claims 1 to 4, wherein curing the filler comprises curing the filler by use of a heat-gun.

8. A substrate processing apparatus, comprising:
a substrate holder configured to hold and rotate a laminated substrate manufactured by bonding a first substrate and a second substrate;
an application module configured to apply a filler, having thermosetting property, to a gap between a peripheral portion of the first substrate and a peripheral portion of the second substrate;
a cure module configured to cure the filler; and
a processing chamber in which the substrate holder, the application module, and the cure module are disposed,
wherein applying and curing of the filler are continuously performed in the processing chamber while rotating the laminated substrate.

9. The substrate processing apparatus according to claim 8, wherein the application module includes a syringe mechanism,
the syringe mechanism includes:
a syringe body filled with the filler; and
a piston movable in the syringe body, and
a tip opening of the syringe body is oppose to the gap.

10. The substrate processing apparatus according to claim 8, wherein the application module includes an ejection mechanism,
the ejection mechanism includes an ejector filled with the filler, and
the ejector has an ejection port opposite to the gap.

11. The substrate processing apparatus according to claim 8, wherein the application module includes a conveyance mechanism, and
the conveyance mechanism includes:
a tube having a discharge port and filled with the filler; and
a filler conveyance member which extends from the discharge port, and which is in close proximity to or contacts the gap.

12. The substrate processing apparatus according to any one of claims 8 to 11, wherein the cure module includes a lamp heater, and
the lamp heater includes:
a lamp; and
an optical device that directs heat from the lamp to the filler.

13. The substrate processing apparatus according to claim 8, wherein the lamp is configured to irradiate a light having a wavelength of 1 µm or more, and
the lamp heater is disposed above or below the laminated substrate.

14. The substrate processing apparatus according to any one of claims 8 to 11, wherein the cure module includes a heat-gun configured to blow a heated gas toward the filler.
